# EUROPEAN PATENT SPECIFICATION

(11) **EP 3 050 112 B1**
(45) Date of publication and mention of the grant of the patent: **15.12.2021**
(21) Application number: 13894364.2
(22) Date of filing: 27.09.2013
(51) Int. Cl.: H01L 29/78, H01L 21/336, H01L 29/20, H01L 29/51, H01L 21/28, H01L 29/423, H01L 29/49, H01L 29/786, H01L 29/10

(54) **COMPOSITE HIGH-K METAL GATE STACK FOR ENHANCEMENT MODE GAN SEMICONDUCTOR DEVICES**
ZUSAMMENGESETZTER HOCH-K-METALL-GATESTAPEL FÜR ANREICHERUNGSTYP-GAN-HALBLEITERBAUELEMENTE
EMPILEMENT DE GRILLES MÉTALLIQUES À K ÉLEVÉ COMPOSITES POUR DISPOSITIFS À SEMI-CONDUCTEUR À GAN À MODE D'ENRICHISSEMENT

(43) Date of publication of application: 03.08.2016
(73) Proprietor: Google LLC, Mountain View, CA 94043 (US)
(72) Inventor: THEN, Han Wui, Portland, Oregon 97229 (US); DASGUPTA, Sansaptak, Hillsboro, Oregon 97124 (US); RADOSAVLJEVIC, Marko, Beaverton, Oregon 97006 (US); CHAU, Robert S., Beaverton, Oregon 97007 (US); SUNG, Seung Hoon, Beaverton, Oregon 97006 (US); GARDNER, Sanaz K., Hillsboro, Oregon 97124 (US)
(74) Representative: Betten & Resch
(86) International application number: PCT/US2013/062314
(87) International publication number: WO 2015/047316

(56) References cited:
- WO-A1-2013/095343
- WO-A1-2013/095377
- WO-A1-2013/103163
- US-A1- 2011 095 267
- US-A1- 2011 140 171
- US-A1- 2011 147 710
- US-A1- 2011 163 297
- US-A1- 2013 069 175
- None

## Description

### TECHNICAL FIELD

Embodiments of the invention are in the field of semiconductor devices and, in particular, enhancement mode gallium nitride (GaN) semiconductor devices having a composite high-k metal gate stack and a method of fabricating one of such devices.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory devices on a chip, lending to the fabrication of products with increased capacity. The drive for ever-more capacity, however, is not without issue. The necessity to optimize the performance of each device becomes increasingly significant.

The mobile computing (e.g., smart phone and tablet) markets benefit from smaller component form factors and lower power consumption. Because current platform solutions for smart phones and tablets rely on multiple packaged integrated circuits (ICs) mounted onto a circuit board, further scaling to smaller and more power efficient form factors is limited. For example, a smart phone will include a separate power management IC (PMIC), radio frequency IC (RFIC), and WiFi/Bluetooth/GPS IC, in addition to a separate logic processor IC. System on Chip (SoC) architectures offer the advantage of scaling, which cannot be matched by board-level component integration. While the logic processor IC may itself be considered a system on a chip (SoC) integrating both memory and logic functions, more extensive SoC solutions for mobile computing platforms have remained elusive because the PMIC and RFIC operate with two or more of high voltage, high power, and high frequency.

As such, conventional mobile computing platforms typically utilize incompatible transistor technologies that are specifically tailored for the different functions performed by the PMIC and RFIC. For example, laterally diffused silicon MOS (LDMOS) technology is typically employed in the PMIC to manage voltage conversion and power distribution (battery voltage regulation including step-up and/or step-down voltage conversion, etc.). Group III-V compound semiconductors, such a GaAs heterojunction bipolar transistors (HBTs), are typically utilized in the RFIC to generate sufficient power amplification at GHz carrier frequencies. Conventional silicon field effect transistors implementing CMOS technology then entail a third transistor technology utilized for logic and control functions within the mobile computing platform. In addition to fundamental semiconductor material incompatibilities between the various ICs in the mobile computing platform, transistor design for DC-to-DC conversion switches in the PMIC has been generally incompatible with the transistor design for high frequency power amplifiers in the RFIC. For example, the relatively low breakdown voltage of silicon requires source-to-drain separation in a DC-to-DC converter switch to be vastly larger than is permissible for a power amplifier transistor needing an Fₜ exceeding 20 GHz, and possibly up to 500 GHz, depending on the carrier frequency (e.g., WPAN is 60 GHz and so transistors need an Fₜ many times 60 GHz). Such different transistor-level design requirements render the fabrication processes for the various transistor designs distinct and difficult to integrate into a single process.

Therefore, while an SoC solution for the mobile computing space that would integrate PMIC and RFIC functions is attractive for improving scalability, lowering costs, and improving platform power efficiency, one barrier to an SoC solution is the lack of a scalable transistor technology having both sufficient speed (i.e., sufficiently high gain cutoff frequency, Fₜ), and sufficiently high breakdown voltage (BV).

Group III-nitride (III-N) devices offer a promising avenue for integration of PMIC and RFIC functions with CMOS as both high BV and Fₜ can be obtained. However, heteroepitaxy of III-N material stacks on silicon substrates poses a technical challenge for at least the reasons of significant lattice mismatch and thermal expansion mismatch, both of which can lead to high defect densities in device layers and poor device performance. Techniques and epitaxial semiconductor stack architectures which can provide reduced defect densities in device layers are therefore advantageous.

Additionally, in the manufacture of integrated circuit devices, multi- gate transistors, such as tri-gate transistors, have become more prevalent as device dimensions continue to scale down. Many different techniques have been attempted to reduce junction leakage of such transistors. However, significant improvements are still needed in the area of junction leakage suppression.

US2011147710 A1 discloses a non-silicon MIS device which includes a gate dielectric stack which comprises at least two layers of non-native oxide or nitride material. The first material layer of the gate dielectric forms an interface with the non-silicon semiconductor surface and has a lower dielectric constant than a second material layer of the gate dielectric. In an embodiment, a dual layer including a first metal silicate layer and a second oxide layer provides both a good quality oxide-semiconductor interface and a high effective gate dielectric constant.

WO2013095343 A1 discloses a group III-N nanowire is disposed on a substrate. A longitudinal length of the nanowire is defined into a channel region of a first group III-N material, a source region electrically coupled with a first end of the channel region, and a drain region electrically coupled with a second end of the channel region. A second group III-N material on the first group III-N material serves as a charge inducing layer, and/or barrier layer on surfaces of nanowire. A gate insulator and/or gate conductor coaxially wraps completely around the nanowire within the channel region. Drain and source contacts may similarly coaxially wrap completely around the drain and source regions.

### BRIEF DESCRIPTION OF THE DRAWINGS

Figure 1 A illustrates a cross-sectional view of a portion of a GaN- based semiconductor device having a polarization layer removed for enhancement mode operation.
Figure IB illustrates a cross-sectional view of a portion of an enhancement mode GaN-based semiconductor device having a tri-layer gate dielectric layer that provides high quality layer-to-layer interfaces, in accordance with an embodiment of the present invention.
Figure 1C is a transmission electron microscope (TEM) image of an implementation of the material stack described in association with Figure IB, where a Pt layer is included as part of the gate electrode, in accordance with an embodiment of the present invention.
Figure 2A is a plot of Is (in A/micron) as a function of Vg (in Volts) for a GaN transistor, not forming part of the present invention, but useful for understanding it.
Figure 2B is a plot of Is (in A/micron) as a function of Vg (in Volts) for GaN devices having increasing SF6 treatment, not forming part of the claimed invention, but useful for understanding it.
Figures 3A-3E illustrate cross-sectional views representing various operations in a method of fabricating a GaN-based semiconductor device having a composite gate dielectric, not forming part of the claimed invention, but useful for understanding it.
Figure 3F illustrates a cross-sectional view of another GaN-based semiconductor device having a composite gate dielectric, in accordance with an embodiment of the present invention.
Figure 4 illustrates an angled view of another GaN-based semiconductor device having a composite gate dielectric, in accordance with an embodiment of the present invention.
Figure 5A illustrates a three-dimensional cross-sectional view of a nanowire-based GaN semiconductor device having a composite gate dielectric, in accordance with an embodiment of the present invention.
Figure 5B illustrates a cross-sectional channel view of the nanowire-based semiconductor structure of Figure 5A, as taken along the a-a' axis, in accordance with an embodiment of the present invention.
Figure 5C illustrates a cross-sectional spacer view of the nanowire-based semiconductor structure of Figure 5A, as taken along the b-b' axis, in accordance with an embodiment of the present invention.
Figure 6 illustrates a computing device not forming part of the claimed invention, but useful for understanding it.
Figure 7 is a functional block diagram of a group III-N SoC implementation of a mobile computing device, not forming part of the claimed invention, but useful for understanding it.

### DESCRIPTION OF THE EMBODIMENTS

The object underlying the claimed invention is achieved by a semiconductor device according to claim 1, by a semiconductor device according to claim 6 and by a manufacturing method for a semiconductor device according to claim 12.

One or more embodiments described herein are directed to composite high-K metal gate stacks for enhancement mode gallium nitride (GaN) transistors, e.g., surface channel GaN-based devices. One or more embodiments may be directed to one or more of gallium nitride technology, high voltage applications, mobile integrated circuits (ICs), power management ICs, RF power amplifiers, system-on-chip (SoC) products and mobile IC products. Aspects may include one or more of: (1) the fabrication of GaN devices suitable for operation in an enhancement mode (i.e., Vt > 0), (2) compatible gate oxide interface, and (3) low gate leakage. In a particular embodiment, a composite gate dielectric stack is formed directly on a GaN layer of a GaN device and a first high band gap Group III-N layer, a second lower k high-k oxide layer, and an third higher k high-k oxide layer.

To provide a more general context, the PMIC and RFIC are critical functional blocks in System-on-Chips (SoCs) found on mobile computing platforms, such as smartphones, tablets, and laptops/netbooks. The PMIC and RFIC are as much important determinants of the power efficiency and form factor of an SoC platform as the logic and memory ICs. GaN transistors conventionally employ 2D electron gas (2D sheet charge) as its transport channel. Such a 2D sheet charge is formed at the abrupt hetero-interface formed by epitaxial deposition of a charge-inducing film with larger spontaneous and piezoelectric polarization, e.g. A1N, AlGaN and AlInN, on GaN. Due to the natural existence of this 2DEG, most GaN transistors are depletion mode devices with threshold gate voltages less than 0V. In most applications, a depletion mode device imposes the requirement for a negative bias voltage to be applied on the gate of the transistor in order to turn the device off. In some application, in order to achieve enhancement mode operation (where the transistor is off at gate voltage of 0V), the top charge-inducing film is etched away. GaN transistors are also mostly fabricated with a Schottky gate because of the lack of a suitable gate dielectric that can simultaneously form a good quality interface with low interface states, and yet provide a sufficient conduction band offset to achieve a low gate leakage. Schottky gates are extremely leaky, with gate leakage current approaching the magnitude of the drain and source currents.

Addressing one or more of the above described issues, in accordance with an embodiment of the present invention, disclosed herein are designs of group III-N composite gate stacks that enable simultaneous achievement of the following desired qualities: (1) fabrication of a well-functioning enhancement mode GaN transistor, (2) a near ideal gate-oxide interface, and (3) low gate leakage.

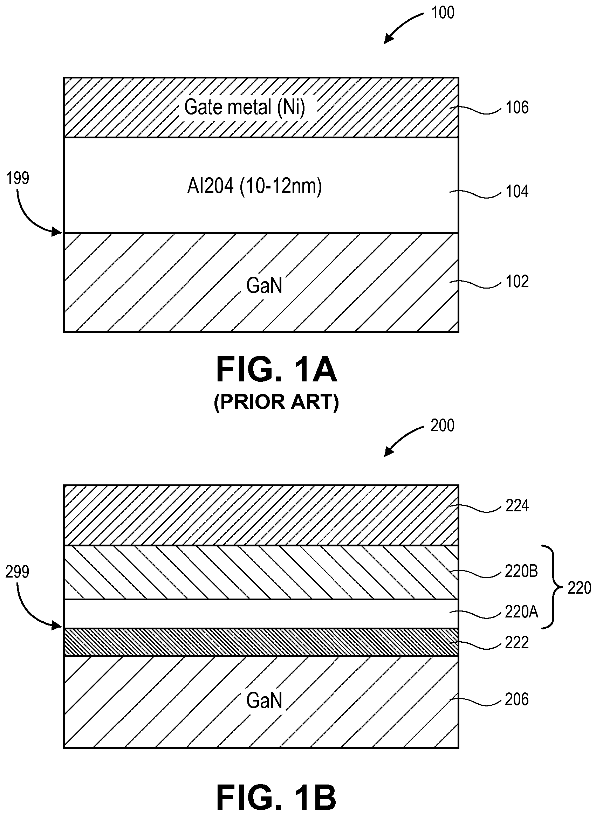

As an example of a conventional approach, Figure 1A illustrates a cross-sectional view of a portion of a GaN-based semiconductor device 100 having a polarization layer removed for enhancement mode operation. Referring to Figure 1A, a GaN channel region 102 has an Al₂O₃ gate dielectric layer 104 with a thickness of 10-12nm disposed directly thereon. A nickel (Ni) metal gate electrode 106 is disposed on the Al₂O₃ gate dielectric layer 104. Typically, the direct contact between the Al₂O₃ gate dielectric layer 104 and the GaN channel region 102 is achieved by first etching with BCL₃ to remove a polarization layer from the GaN channel region 102, revealing a BCl₃-exposed surface 199; this is followed by deposition of the Al₂O₃ gate dielectric layer 104. For the example shown in Figure 1A, challenges remain for remedying damage to the GaN channel region 102 incurred by the BCl₃ based etching. Additionally, high interface states can plague the device 100 due to direct oxide deposition of oxide on the GaN channel. Furthermore, a relatively thick Al₂O₃ layer is typically required to reduce gate leakage because of the absence of conduction band offset between GaN and the Al2O3, which would otherwise be present in the case of a retained polarization layer.

By contrast to Figure 1A, Figure 1B illustrates a cross-sectional view of a portion of an enhancement mode GaN-based semiconductor device 200 having a tri-layer gate dielectric layer that provides high quality layer-to-layer interfaces, in accordance with an embodiment of the present invention. Referring to Figure 1B, a GaN channel region 206 has a composite gate dielectric stack (222 + 220) formed directly thereon. The composite gate dielectric stack is a tri-layer stack including a high band gap Group III-N layer 222 and a composite high-K material stack 220. The composite high-K material stack 220 includes a lower K high-K oxide layer 220A and a higher K high-K oxide layer 220B. The three layers 222, 220A and 220B together form the gate dielectric for GaN-based device 200. A gate electrode 224 is formed on the composite high-K material stack 220 to complete the gate/channel portion of device 200.

In an embodiment, the GaN device 200 is a surface channel device in that charge migration is predominately at the interface of the GaN channel region 206 and the first layer 222 of the gate dielectric stack. In accordance with an embodiment of the present invention, a GaN-based transistor based on the material stack shown in Figure 1B is suitable for enhancement mode operation, has a near ideal subthreshold slope (SS), and has low gate leakage. In a particular embodiment, the GaN material layer 206 has a (0001) wurtzite crystal plane and has a thickness of approximately 50 nanometers. Although shown in Figure 1B as a planar device layer stack, multi-gate devices may also be fabricated when considering that layers 222, 220 and 224 may be disposed on more than one surface, i.e., wrap more than a single planar surface, of the GaN channel material regions. Such arrangements are described in greater detail below. Furthermore, although not shown, source and drain regions may be formed on either side of the channel region of device 200. In one such embodiment, a GaN layer is undercut and embedded source/drain regions of another III-V material layer (such as InGaN) are formed in the undercut regions. In another embodiment, source and drain regions are formed by highly doping GaN portions on either side of the channel regions with silicon (e.g., for an N-type device).

The high band gap Group III-N layer 222, which is the first layer of the gate dielectric layer of device 200, is a high band gap material including A1 and N such as, but not limited to, AlInGaN, AlGaN, AlInN. According to the claimed invention, the high band gap Group III-N layer 222 is composed of AlInN. The AlInN may have one or more of the following properties beneficial for device 200: (1) a high Ec Band offset to GaN, (2) forms an excellent interface with GaN, (3) wide bandgap (e.g., 5.6eV), energy gap comparable to that of HfO₂, (4) a lattice matched to GaN, (5) Al₂O₃ is an oxide layer compatible therewith. In a particular embodiment, the AlInN layer is a layer having a composition of AlₓIn_{y}N where 0.81 < x <1 and 0 < y< 0.19. In an unclaimed embodiment, the In in the AlInN layer is substituted with GaIn where more In is present than Ga. In an embodiment the AlInN layer has a thickness approximately in the range of 1-2.5nm.

The composite high-K material stack 220, which includes the second and third layers of the gate dielectric layer of device 200, includes two layers of atomic layer deposited (ALD) oxide dielectric in a combination of a higher K high-K layer (e.g., K > 15) and lower K high-K layer (e.g., K < 15) disposed on the high band gap Group III-N layer 222, with the lower K high-K layer proximate to the high band gap Group III-N layer 222. In one such embodiment, a top layer (farthest from the channel) of the composite gate dielectric stack is composed of HfO2 and has a thickness approximately in the range of 1-5nm, and a middle layer of the composite gate dielectric stack is composed of Al₂O₃ and has a thickness approximately in the range of 1-4nm. According to the claimed invention, the composite high-K oxide portion of the dielectric stack includes a first Al₂O₃ layer for good interface quality with layer 222, and includes a higher K material thereon (e.g., HfO_{2,} ZrO₂, or Ta₂O₅).

In an embodiment, the gate electrode 224 is disposed on the composite high-K material stack 220 and is a metal gate electrode. In one such embodiment, the workfunction of the metal gate electrode is a mid-gap workfunction for a GaN-based semiconductor device. In an embodiment, the metal gate electrode 224 is a layer (or includes a workfunction-dominating layer) of a metal such as, but not limited to, titanium nitride (TiN), nickel (Ni), platinum (Pt), or tungsten (W).

Referring again to Figure 1B, an interface 299 is between the high band gap Group III-N layer 222 and the first high-K oxide layer of the composite high-K oxide portion of the composite gate dielectric layer stack. In an embodiment, prior to formation of the first high-K oxide layer, the surface of layer 222 is treated with an SF₆ plasma. In one such embodiment, the SF₆ plasma treatment is performed at a plasma bias of between 50-200W. In an embodiment, such introduction of sulfur- and fluoride-based pre-treatment chemistry (e.g., SF₆) provides for a stable interface between the surface of layer 222 and the first high-K oxide layer. In one embodiment, the high band gap Group III-N layer 222 is treated with the SF₆ treatment and as deposited. In another embodiment, the high band gap Group III-N layer 222 is treated following deposition and subsequent thinning of the layer, e.g., by an etch process. In an exemplary embodiment, the underlying GaN material is first deposited with a temperature ramp up of approximately 700-1050 degrees Celsius, the high band gap Group III-N layer 222 is next deposited with a temperature ramp down of approximately 1050-600, degrees Celsius, and the SF₆ treatment is then performed.

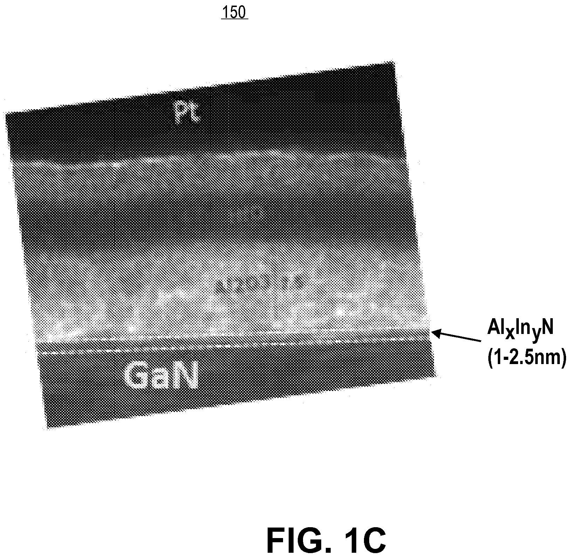

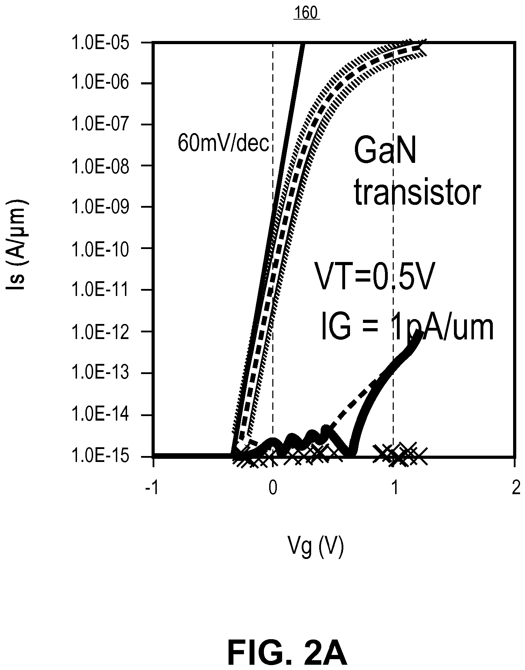

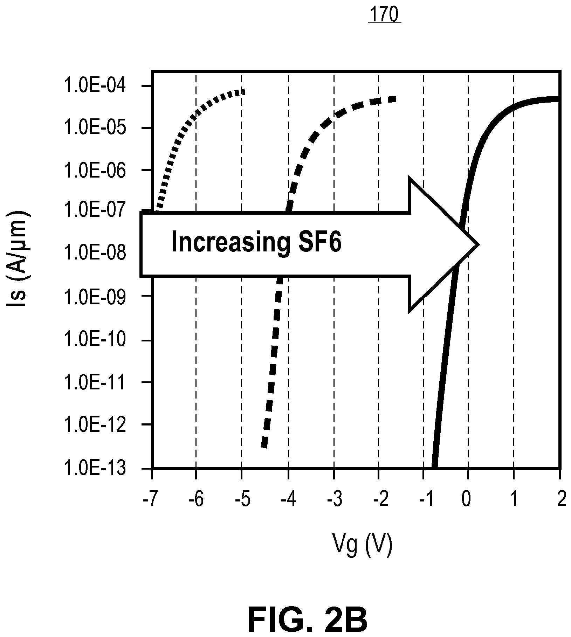

With respect to actual stack and/or device fabrication, Figure 1C is a transmission electron microscope (TEM) image 150 of an implementation of the material stack described in association with Figure 1B, where a Pt layer is included as part of the gate electrode, in accordance with an embodiment of the present invention. Figure 2A is a plot 160 of Is (in A/micron) as a function of Vg (in Volts) for a GaN transistor, in accordance with an embodiment of the present invention. Referring to plot 160, the subthreshold slope is close to ideal 60 mV/decade at a Vt of 0.5 Volts and an Ig of 1pA/micron. Figure 2B is a plot 170 of Is (in A/micron) as a function of Vg (in Volts) for GaN devices having increasing SF₆ treatment, in accordance with an embodiment of the present invention. Referring to plot 170, Vt shifts to enhancement mode with increasing interface treatment. Furthermore, subthreshold slope matching reveals that no damage is incurred from the SF₆ treatments. Overall, referring to Figures 1C, 2A and 2B, a GaN-based device stack such as shown in image 150 can be fabricated with one or more of the following attributes: (1) enhancement mode GaN, threshold voltage = 0.5V, (2) near ideal SS of 60mV/dec, (3) low gate leakage, IG=1pA/um.

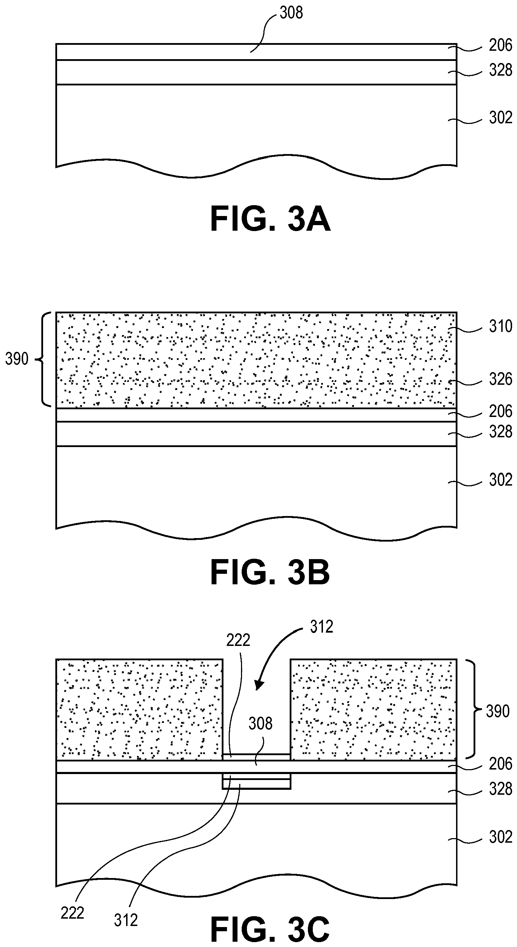

In one aspect, methods of fabricating a GaN-based semiconductor structure with a tri-layer gate dielectric layer including a composite high-k gate dielectric stack are provided. For example, Figures 3A-3E illustrate cross-sectional views representing various operations in a method of fabricating a GaN-based semiconductor device having a composite gate dielectric, not forming part of the claimed invention, but useful for understanding it. It is to be understood that like feature designations of Figures 3A-3E may be as described in association with Figure 1B.

Referring to Figure 3A, a bottom barrier layer 328 is formed above a substrate 302. A GaN layer is then formed on bottom barrier layer 328 and patterned to form three-dimensional GaN body 206 with channel region 308. Alternatively, the GaN layer may be formed after or during the trench formation described below in association with Figure 3C.

Referring to Figure 3B, a hetero-structure 390, which may include a top barrier layer 326 and source and drain material region 310, is formed above the three-dimensional GaN body 206 (or above the GaN layer, if not yet patterned).

Referring to Figure 3C, a trench 312 is formed in hetero-structure 390 and partially into bottom barrier layer 328, exposing channel region 308 of the three-dimensional GaN body 206. Trench 312 is formed by a dry or wet etch process. A high band gap Group III-N layer 222, as a first later of a gate dielectric stack, is then formed on the exposed channel region 308 of the three-dimensional GaN body 206, examples of which are described in association with Figure 1B. Alternatively, the material of such a layer 222 may have been formed previously and then etched back at this stage.

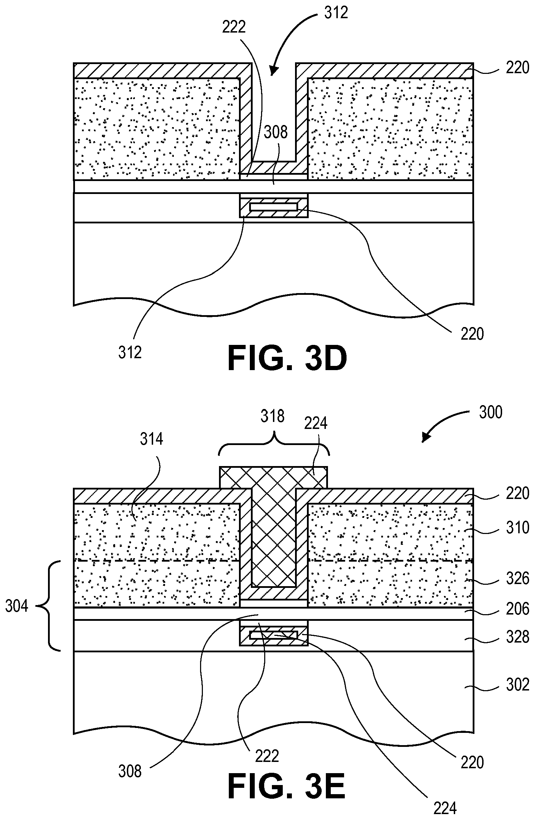

Referring to Figure 3D, a composite high-K stack 220 (forming second and third layers of the gate dielectric layer) is formed in trench 312 and surrounding the high band gap Group III-N layer 222 and, hence, the channel region 308. Then, referring to Figure 3E, a gate electrode 224 is formed on the composite high-K stack 220.

Thus, Figure 3E illustrates a cross-sectional view of a non-planar semiconductor device 300 having a GaN active region with a tri-layer gate dielectric layer. Referring again to Figure 3E, then the semiconductor device 300 includes a hetero-structure 304 disposed above the substrate 302. The hetero-structure 304 includes the three-dimensional GaN body 206 having the channel region 308. The source and drain material region 310 is disposed above the three-dimensional GaN body 206. A trench is disposed in the source and drain material region 310, separating a source region 314 from a drain region 316, and exposing at least a portion of the channel region 308 (having the first layer 222 of gate dielectric thereon). A gate stack 318 is disposed in the trench and on the exposed portion of the layer 222. The gate stack 218 includes the composite dielectric stack 220 and the gate electrode 224. Although depicted as T-shaped, gate electrode 224 may instead have the T-portions trimmed in order to reduce capacitance effects. It is to be appreciated that the gate stack 318 includes a portion below the channel region 308, as is depicted in Figure 3E.

Referring again to Figure 3E, embodiment, the hetero-structure 304 further includes a top barrier layer 326 (shown by the dashed lines in Figure 3E) disposed between the source and drain material region 310 and the GaN body 206. The trench is also disposed in the top barrier layer 326. The hetero-structure 304 further includes the bottom barrier layer 328 disposed between the substrate 302 and the three-dimensional GaN body 206. The trench is also partially disposed in the bottom barrier layer 328, completely exposing the high band gap Group III-N layer 222 on the channel region 308. The gate stack 318 completely surrounds the channel region 308, as indicated in Figure 3E.

Substrate 302 may be composed of a material suitable for semiconductor device fabrication. Substrate 302 is a bulk substrate composed of a single crystal of a material which may include, but is not limited to, silicon, germanium, silicon-germanium or a III-V compound semiconductor material. Substrate 302 includes a bulk layer with a top epitaxial layer. The bulk layer is composed of a single crystal of a material which may include, but is not limited to, silicon, germanium, silicon-germanium, a III-V compound semiconductor material or quartz, while the top epitaxial layer is composed of a single crystal layer which may include, but is not limited to, silicon, germanium, silicon-germanium or a III-V compound semiconductor material. Substrate embodiment, 302 includes a top epitaxial layer on a middle insulator layer which is above a lower bulk layer. The top epitaxial layer is composed of a single crystal layer which may include, but is not limited to, silicon (e.g., to form a silicon-on-insulator (SOI) semiconductor substrate), germanium, silicon-germanium, SiC, sapphire or a III-V compound semiconductor material. The insulator layer is composed of a material which may include, but is not limited to, silicon dioxide, silicon nitride or silicon oxy-nitride. The lower bulk layer is composed of a single crystal which may include, but is not limited to, silicon, germanium, silicon-germanium, SiC, sapphire, a III-V compound semiconductor material or quartz. Substrate 302 may further include dopant impurity atoms.

Hetero-structure 304 includes a stack of one or more crystalline semiconductor layers, such as a compositional buffer layer (not shown) with the bottom barrier layer 328 disposed thereon. The compositional buffer layer may be composed of a crystalline material suitable to provide a specific lattice structure onto which a bottom barrier layer may be formed with negligible dislocations. For example, the compositional buffer layer is used to change, by a gradient of lattice constants, the exposed growth surface of semiconductor hetero-structure 304 from the lattice structure of substrate 302 to one that is more compatible for epitaxial growth of high quality, low defect layers thereon. The compositional buffer layer acts to provide a more suitable lattice constant for epitaxial growth instead of an incompatible lattice constant of substrate 302. Substrate 302 is composed of single-crystal silicon and the compositional buffer layer grades to a bottom barrier layer composed of a layer of InAlN having a thickness of approximately 1 micron. The compositional buffer layer is omitted because the lattice constant of substrate 302 is suitable for the growth of a bottom barrier layer 328 for a quantum-well semiconductor device.

The bottom barrier layer 328 may be composed of a material suitable to confine a wave-function in a quantum-well formed thereon. The bottom barrier layer 328 has a lattice constant suitably matched to the top lattice constant of the compositional buffer layer, e.g., the lattice constants are similar enough that dislocation formation in the bottom barrier layer 328 is negligible. The bottom barrier layer 328 is composed of a layer of approximately In_{0.17}Al_{0.83}N having a thickness of approximately 10 nanometers. The embodiment, bottom barrier layer 328 composed of the layer of approximately In_{0.17}Al_{0.83}N In_{0.65}Al_{0.35}As is used for quantum confinement in an N-type semiconductor device.

The three-dimensional GaN body 206 may be composed of a material suitable to propagate a wave-function with low resistance. Three-dimensional GaN body 206 has a lattice constant suitably matched to the lattice constant of the bottom barrier layer 328 of hetero-structure 304, e.g., the lattice constants are similar enough that dislocation formation in three-dimensional GaN body 206 is negligible. The three-dimensional GaN body 206 may have a thickness suitable to propagate a substantial portion of a wave-function, e.g. suitable to inhibit a significant portion of the wave-function from entering the bottom barrier layer 328 of hetero-structure 304 or a top barrier layer (e.g., barrier layer 326) formed on three-dimensional GaN body 206. Three-dimensional GaN body 206 has a thickness (height) approximately in the range of 50 -200 Angstroms. The width (dimension taken into the page as shown) may have approximately the same dimension, providing a three-dimensional wire-type feature.

Top barrier layer 326 may be composed of a material suitable to confine a wave-function in, and induce the formation of 2D electron gas in the III-V material body/channel region formed there under. Top barrier layer 326 preferably has a lattice constant suitably matched to the lattice constant of GaN body 206, e.g., Al_{0.83}In_{0.17}N where the lattice constants are similar enough that dislocation formation in top barrier layer 326 is negligible. Top barrier 326 may consist of two or more interlayers, e.g. AlN/AlInN, AIN/AlGaN, AlN/AlGaN/AlInN, if the non-lattice matching layers such as AlN, AlGaN or AlₓIn₁₋ₓN where x is other than 0.83. Source and drain material region 310 may be doped group III-V material region, such a more heavily doped structure formed from the same or similar material as top barrier layer 326. Alternatively, the composition of source and drain material region 310, aside from doping differences, differs from the material of top barrier layer 326, for e.g., GaN, InN or In_{y}Ga_{1-y}N.

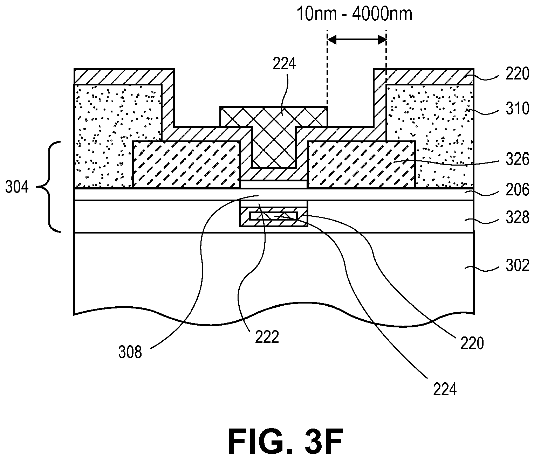

In another embodiment, in accordance with the claimed invention, shown in Fig. 3F, a double trench is formed in the gate region by well-known lithographic techniques where the source/drain 310 is further laterally spaced by 10 nm and up to 4000 nm from gate 224. This has the advantage of increasing the gate-to-drain breakdown voltage of the device from ~3V up to 1000V. In the particular embodiment shown in Fig. 3F, the barrier material 326 is etched prior to the deposition of source/drain material 310 to enable direct contact to channel material 206 for low contact resistance.

Semiconductor device 200 or 300 is a semiconductor device incorporating a gate, a channel region and a pair of source/drain regions. In an embodiment, semiconductor device 200 or 300 is one such as, but not limited to, a MOS-FET or a Microelectromechanical System (MEMS). In one embodiment, semiconductor device 200 or 300 is a planar or three-dimensional MOS-FET and is an isolated device or is one device in a plurality of nested devices. As will be appreciated for a typical integrated circuit, both N- and P-channel transistors may be fabricated on a single substrate to form a CMOS integrated circuit. Furthermore, additional interconnect wiring may be fabricated in order to integrate such devices into an integrated circuit.

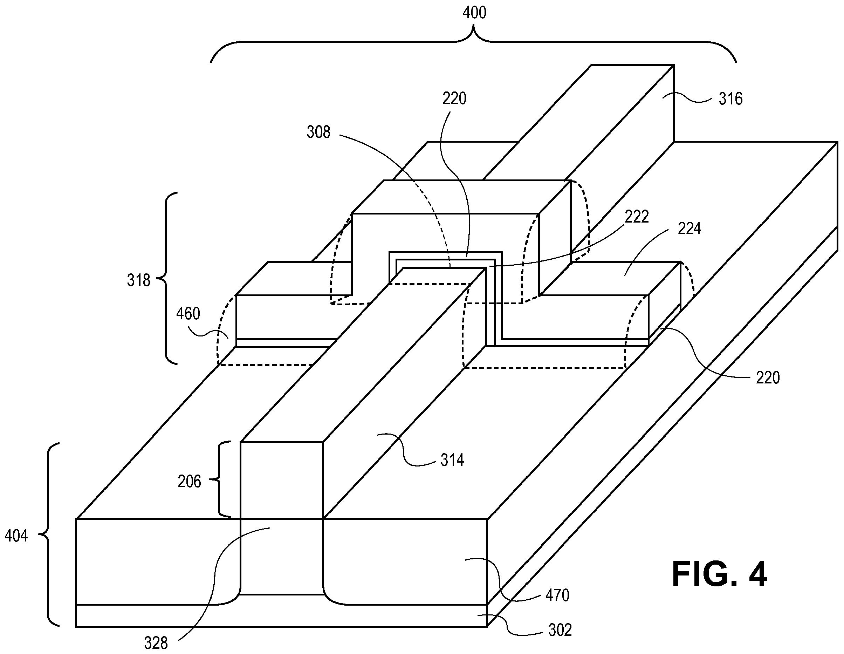

The above described devices can be viewed as trench-based devices, where a gate wraps a channel region within a trench of a stack of III-V material layers. However, other devices may include a protruding GaN channel regions, such as in a tri-gate or FIN-FET based MOS-FETs. For example, Figure 4 illustrates an angled view of another GaN-based semiconductor device having a tri-layer gate dielectric layer including a composite high-k gate dielectric stack, in accordance with an embodiment of the present invention.

Referring to Figure 4, a semiconductor device 400 includes a hetero-structure 404 disposed above a substrate 302. The hetero-structure 404 includes a bottom barrier layer 328. A three-dimensional GaN body 206 with a channel region 308 is disposed above the bottom barrier layer 328. A gate stack 318 is disposed to surround at least a portion of the channel region 308. In an embodiment, not viewable from the perspective of Figure 4, the gate stack completely surrounds the channel region 308. The gate stack 318 includes a gate electrode 224 and a composite gate dielectric layer including a high band gap Group III-N layer 222 and a composite high-K dielectric stack 220. The gate stack may further include dielectric spacers 460.

Source and drain regions 314/316 may be formed in or on portions of the three-dimensional GaN material body 206 not surrounded by gate stack 318. Furthermore, a top barrier layer may be included in those regions as well. Also, isolation regions 470 may be included. Although depicted in Figure 4 as being somewhat aligned with the bottom of the bottom barrier layer 328, it is to be understood that the depth of the isolation regions 470 may vary. Also, although depicted in Figure 4 as being somewhat aligned with the top of the bottom barrier layer 328, it is to be understood that the height of the isolation regions 470 may vary. It is also to be understood that like feature designations of Figure 4 may be as described in association with Figures 1B and 3A-3E.

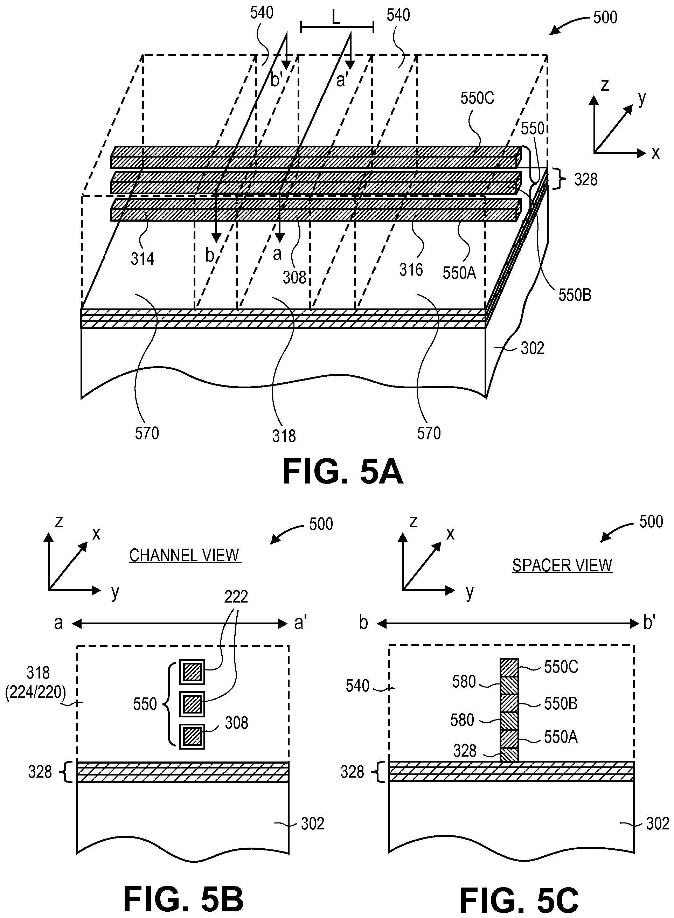

In another aspect, Figure 5A illustrates a three-dimensional cross-sectional view of a GaN nanowire-based semiconductor structure having a tri-layer gate dielectric layer including a composite high-k gate dielectric stack, in accordance with an embodiment of the present invention. Figure 5B illustrates a cross-sectional channel view of the GaN nanowire-based semiconductor structure of Figure 5A, as taken along the a-a' axis. Figure 5C illustrates a cross-sectional spacer view of the GaN nanowire-based semiconductor structure of Figure 5A, as taken along the b-b' axis.

Referring to Figure 5A, a semiconductor device 500 includes one or more vertically stacked GaN nanowires (550 set) disposed above a substrate 302. Embodiments herein are targeted at both single wire devices and multiple wire devices. As an example, a three nanowire-based devices having nanowires 550A, 550B and 550C is shown for illustrative purposes. For convenience of description, nanowire 550A is used as an example where description is focused on only one of the nanowires. It is to be understood that where attributes of one nanowire are described, embodiments based on a plurality of nanowires may have the same attributes for each of the nanowires.

At least the first nanowire 550A includes a GaN channel region 308. The GaN channel region 308 has a length (L). Referring to Figure 5B, the GaN channel region 308 also has a perimeter orthogonal to the length (L). Referring to both Figures 5A and 5B, a gate electrode stack 318 surrounds the entire perimeter of each of the channel regions of each nanowire 550, including GaN channel region 308. The gate electrode stack 318 includes a gate electrode along with a composite gate dielectric layer stack disposed between the channel regions and the gate electrode. The composite gate dielectric layer stack includes a high band gap Group III-N layer 222 (shown in Figure 5B) and a composite high-k dielectric layer stack, such a dual high-K oxide stack (not individually shown). The GaN channel region 308 and the channel regions of the additional nanowires 550B and 550C are discrete in that they are completely surrounded by the gate electrode stack 318 without any intervening material such as underlying substrate material or overlying channel fabrication materials. Accordingly, in embodiments having a plurality of nanowires 550, the channel regions of the nanowires are also discrete relative to one another, as depicted in Figure 5B. Referring to Figures 5A-5C, a bottom barrier layer 328 is disposed above substrate 302. The bottom barrier layer 328 is further disposed below the one or more nanowires 550. In an embodiment, the GaN channel region 308 is completely surrounded by gate electrode 318, as depicted in Figure 5B.

Referring again to Figure 5A, each of the nanowires 550 also includes source and drain regions 314 and 316 disposed in or on the nanowire on either side of the channel regions, including on either side of GaN channel region 308. In an embodiment, the source and drain regions 314/316 are embedded source and drain regions, e.g., at least a portion of the nanowires is removed and replaced with a source/drain material region. However, in another embodiment, the source and drain regions 314/316 are composed of, or at least include, portions of the one or more nanowires 550.

A pair of contacts 570 is disposed over the source/drain regions 314/316. In an embodiment, the semiconductor device 500 further includes a pair of spacers 540. The spacers 540 are disposed between the gate electrode stack 318 and the pair of contacts 570. As described above, the channel regions and the source/drain regions are, in at least several embodiments, made to be discrete. However, not all regions of the nanowires 550 need be, or even can be made to be discrete. For example, referring to Figure 5C, nanowires 550A-550C are not discrete at the location under spacers 540. In one embodiment, the stack of nanowires 550A-550C have intervening semiconductor material 580 there between. In one embodiment, the bottom nanowire 550A is still in contact with a portion of the bottom buffer layer 328, which is otherwise recessed for gate stack 318 formation (Figure 5B). Thus, in an embodiment, a portion of the plurality of vertically stacked nanowires 550 under one or both of the spacers 540 is non-discrete.

It is to be understood that like feature designations of Figure 5A-5C may be as described in association with Figures 1B, 3A-3E and 4. Also, although the device 500 described above is for a single device, a CMOS architecture may also be formed to include both NMOS and PMOS nanowire-based devices disposed on or above the same substrate. In an embodiment, the nanowires 550 may be sized as wires or ribbons, and may have squared-off or rounded corners.

Thus, one or more embodiments described herein are targeted at GaN active region arrangements integrated with composite gate dielectrics. Although described above with respect to benefits for non-planar and gate-all-around devices, benefits may also be achieved for planar devices without gate wrap-around features. Thus, such arrangements may be included to form GaN-based transistors such as planar devices, fin or tri-gate based devices, and gate all around devices, including nanowire-based devices. Embodiments described herein may be effective for junction isolation in metal-oxide-semiconductor field effect transistors (MOSFETs). It is to be understood that formation of materials such as the III-V material layers described herein may be performed by techniques such as, but not limited to, chemical vapor deposition (CVD) or molecular beam epitaxy (MBE), or other like processes.

Embodiments described herein cover (1) a composite oxide (oxide-semiconductor stack) having two layers of ALD dielectric in a combination of a higher high-K (e.g., K > 15) and a lower high-K (e.g., K < 15) on a thin (e.g., 1-2.5nm) AlₓIn₁₋ₓN (e.g., x = 0.83) layer, (2) introduction of sulphur- and fluoride-based pre-treatment chemistry (e.g., SF₆) to AlₓIn₁₋ₓN (e.g., x = 0.83) surfaces, and (3) enhancement mode operability for GaN based devices. It is to be understood that the above material and processing parameters may be suitable to fabricate GaN-based devices that are free from a polarization layer or, in other cases, incorporating a polarization layer at, e.g., the source and drain regions of the device.

In general, one or more embodiments described herein is relevant to SoC products (including SoCs targeted at smartphones and tablets) that will require direct battery high voltage switching transistors such as for DC-to-DC conversion in the output filter as well as in the drive circuitries. For example, DC-to-DC convertors are required in power management ICs found in SoC circuits in smartphones, notebooks, tablets, and other electronic gadgets. Consumers are demanding smaller form factors to accommodate more ICs for more functionality; one or more embodiments described herein enable such reduction in form factor with increasing functionality. One or more embodiments may also be directed to other industries, such as base station wireless transmissions technology, electric power conversion technology in power transmission networks, and technology for electric vehicles.

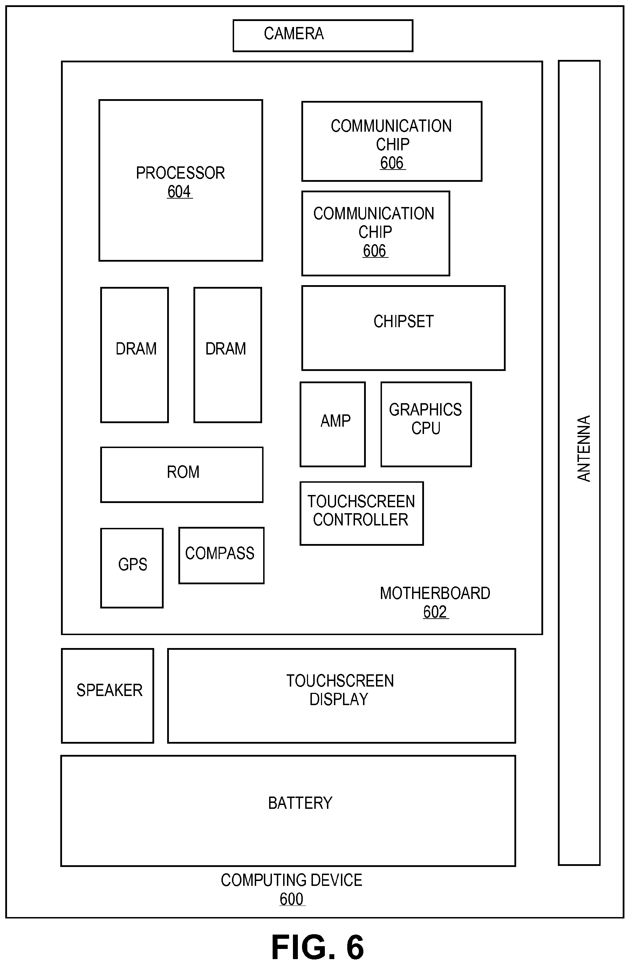

Figure 6 illustrates a computing device 600 not forming part of the claimed invention, but useful for understanding it. The computing device 600 houses a board 602. The board 602 may include a number of components, including but not limited to a processor 604 and at least one communication chip 606. The processor 604 is physically and electrically coupled to the board 602. In some implementations the at least one communication chip 606 is also physically and electrically coupled to the board 602. In further implementations, the communication chip 606 is part of the processor 604.

Depending on its applications, computing device 600 may include other components that may or may not be physically and electrically coupled to the board 602. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 606 enables wireless communications for the transfer of data to and from the computing device 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some examples they might not. The communication chip 606 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing device 600 includes an integrated circuit die packaged within the processor 604. In some implementations of the invention, the integrated circuit die of the processor includes one or more devices, such as GaN-based MOS-FET transistors built in accordance with implementations of the invention. The term "processor" may refer to any device or portion of a device that processes electronic data from registers and/or memory to transform that electronic data into other electronic data that may be stored in registers and/or memory.

The communication chip 606 also includes an integrated circuit die packaged within the communication chip 606. In accordance with another example, the integrated circuit die of the communication chip includes one or more devices, such as GaN-based MOS-FET transistors built in accordance with implementations of the invention.

In further implementations, another component housed within the computing device 600 may contain an integrated circuit die that includes one or more devices, such as GaN-based MOS-FET transistors built in accordance with implementations of the invention.

In various implementations, the computing device 600 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 600 may be any other electronic device that processes data.

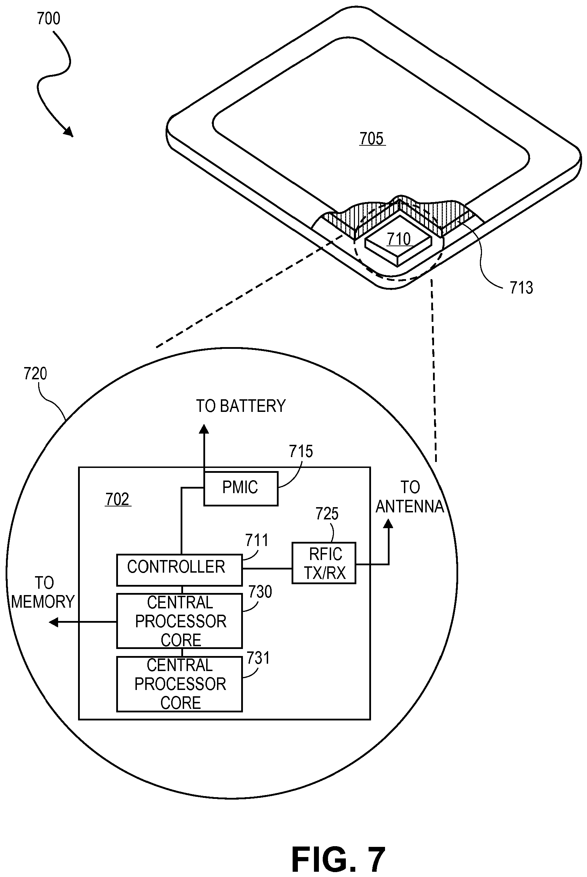

Figure 7 is a functional block diagram of a SoC implementation of a mobile computing platform, not forming part of the claimed invention, but useful for understanding it. The mobile computing platform 700 may be any portable device configured for each of electronic data display, electronic data processing, and wireless electronic data transmission. For example, mobile computing platform 700 may be any of a tablet, a smart phone, laptop computer, etc. and includes a display screen 705 that is in the example a touchscreen (e.g., capacitive, inductive, resistive, etc.) permitting the receipt of user input, the SoC 710, and a battery 713. As illustrated, the greater the level of integration of the SoC 710, the more of the form factor within the mobile computing platform 700 that may be occupied by the battery 713 for longest operative lifetimes between charging, or occupied by memory (not depicted), such as a solid state drive, for greatest functionality.

Depending on its applications, mobile computing platform 700 may include other components including, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The SoC 710 is further illustrated in the expanded view 720. Depending on the example, the SoC 710 includes a portion of a substrate 702 (i.e., a chip) upon which two or more of a power management integrated circuit (PMIC) 715, RF integrated circuit (RFIC) 725 including an RF transmitter and/or receiver, a controller thereof 711, and one or more central processor core 730, 731 is fabricated. The RFIC 725 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The RFIC 725 may include a plurality of communication chips. For instance, a first communication chip may be dedicated to shorter range wireless communications such as Wi-Fi and Bluetooth and a second communication chip may be dedicated to longer range wireless communications such as GPS, EDGE, GPRS, CDMA, WiMAX, LTE, Ev-DO, and others.

As will be appreciated by one of skill in the art, of these functionally distinct circuit modules, CMOS transistors are typically employed exclusively except in the PMIC 715 and RFIC 725. In examples not forming part of the claimed invention, but useful for understanding it, the PMIC 715 and RFIC 725 employ one or more of the gallium nitride transistors as described herein. In further examples the PMIC 715 and RFIC 725 employing the gallium nitride transistors described herein are integrated with one or more of the controller 711 and processor cores 730, 731 provided in silicon CMOS technology monolithically integrated with the PMIC 715 and/or RFIC 725 onto the (silicon) substrate 702. It will be appreciated that within the PMIC 715 and/or RFIC 725, the high voltage, high frequency capable gallium nitride transistors described herein need not be utilized in exclusion to CMOS, but rather silicon CMOS may be further included in each of the PMIC 715 and RFIC 725.

The gallium nitride transistors described herein may be specifically utilized where a high voltage swings present (e.g., 7-10V battery power regulation, DC-to-DC conversion, etc. within the PMIC 715). As illustrated, in the example the PMIC 715 has an input coupled to the battery 713 and has an output provide a current supply to all the other functional modules in the SoC 710. In a further example, where additional ICs are provided within the mobile computing platform 700 but off the SoC 710, the PMIC 715 output further provides a current supply to all these additional ICs off the SoC 710.

As further illustrated, in the example the PMIC 715 has an output coupled to an antenna and may further have an input coupled to a communication module on the SoC 710, such as an RF analog and digital baseband module (not depicted). Alternatively, such communication modules may be provided on an IC off-chip from the SoC 710 and coupled into the SoC 710 for transmission. The gallium nitride transistors described herein may further provide the large power added efficiency (PAE) needed from a power amplifier transistor having an Fₜ of at least ten times carrier frequency (e.g., a 1.9 GHz in an RFIC 725 designed for 3G or GSM cellular communication).

## Claims

1. A semiconductor device, comprising:
a gallium nitride, GaN, channel region (206) disposed above a substrate;
a gate stack (222, 220) disposed on the GaN channel region (206), the gate stack (222, 220) comprising a composite gate dielectric layer disposed directly between the GaN channel region (206) and a gate electrode (224), wherein the composite gate dielectric layer comprises a high band gap Group III-N layer (222), the high band gap Group III-N layer (222) comprising AlInN, a first high-K dielectric oxide layer (220A) on the high band gap Group III-N layer (222), the first high-K dielectric oxide layer (220A) comprising aluminum oxide, Al2O3, and a second high-K dielectric oxide layer (220B) on the first high-K dielectric oxide layer (220A), the second high-K dielectric oxide layer (220B) having a higher dielectric constant than the first high-K dielectric oxide layer (220A); wherein the gate electrode is disposed on the second high-K dielectric oxide layer; and
source/drain regions disposed on either side of the GaN channel region (206).

2. The semiconductor device of claim 1, wherein the second high-K dielectric oxide layer (220B) comprises hafnium oxide, HfO₂.

3. The semiconductor device of one of claims 1-2, wherein the second high-K dielectric oxide layer (220B) has a dielectric constant greater than 15, and the first high-K dielectric oxide layer (220A) has a dielectric constant less than 15.

4. The semiconductor device of one of claims 1-3, wherein the semiconductor device is an N-type device, the gate electrode (224) is a mid-gap metal gate electrode (224), and the source and drain regions comprises heavily Si-doped GaN regions.

5. The semiconductor device of one of claims 1-4, wherein the semiconductor device is an enhancement mode device.

6. A semiconductor device, comprising:
a hetero-structure disposed above a substrate (302) and comprising a three-dimensional gallium nitride, GaN, body with a surface GaN channel region (206);
a source and drain material region (310) disposed above the three-dimensional GaN body;
a trench disposed in the source and drain material region separating a source region from a drain region, and exposing at least a portion of the surface GaN channel region (206); and
a gate stack (222, 220) disposed in the trench and on the exposed portion of the surface GaN channel region (206), the gate stack (222, 220) comprising a composite gate dielectric layer disposed directly between the surface GaN channel region (206) and a gate electrode (224), wherein the composite gate dielectric layer comprises a high band gap Group III-N layer (222), the high band gap Group III-N layer (222) comprising AlInN, a first high-K dielectric oxide layer (220A) on the high band gap Group III-N layer (222), the first high-K dielectric oxide layer (220A) comprising aluminum oxide, Al2O3, and a second high-K dielectric oxide layer (220B) on the first high-K dielectric oxide layer (220A), the second high-K dielectric oxide layer (220B) having a higher dielectric constant than the first high-K dielectric oxide layer (220A) and wherein the gate electrode is disposed on the second high-K dielectric oxide layer.

7. The semiconductor device of claim 6, wherein the second high-K dielectric oxide layer (220B) comprises hafnium oxide, HfO2.

8. The semiconductor device of one of claims 6-7, wherein the second high-K dielectric oxide layer (220B) has a dielectric constant greater than 15, and the first high-K dielectric oxide layer (220A) has a dielectric constant less than 15.

9. The semiconductor device of one of claims 6-9, wherein the semiconductor device is an N-type device, and the gate electrode (224) is a mid-gap metal gate electrode (224).

10. The semiconductor device of one of claims 6-9, wherein the semiconductor device is an enhancement mode device.

11. The semiconductor device of one of claims 6-10, the hetero-structure (304) further comprising:
a top barrier layer (326)
disposed between the source and drain material region and the three-dimensional GaN body, wherein the trench is also disposed in the top barrier layer; and
a bottom barrier layer (328) disposed between the substrate and the three-dimensional GaN body, wherein the trench is also partially disposed in the bottom barrier layer, completely exposing the surface GaN channel region (206), and wherein the gate stack (222, 220) completely surrounds the surface GaN channel region (206).

12. A method of fabricating a semiconductor device, the method comprising:
forming a gallium nitride, GaN, channel region (206) above a substrate;
forming a high band gap Group III-N layer (222) on the GaN channel region (308), the
high band gap Group III-N layer (222) comprising AlInN;
treating the high band gap Group III-N layer (222) with SF₆;
forming a first high-K dielectric oxide layer (220A) on the high band gap Group III-N
layer (222), the first high-K dielectric oxide layer (220A) comprising aluminum oxide, Al2O₃;
forming a second high-K dielectric oxide layer (220B) on the first high-K dielectric oxide
layer (220A), the second high-K dielectric oxide layer (220B) having a higher dielectric constant than the first high-K dielectric oxide layer (220A);
forming a gate electrode (224) on the second high-K dielectric oxide layer (220B); and
forming source/drain regions on either side of the GaN channel region (206).

13. The method of claim 12, wherein forming the high band gap Group III-N layer (222) comprises forming the high band gap Group III-N layer (222) to a first thickness and, subsequently, etching the high band gap Group III-N layer (222) to a second, lesser, thickness.

## Patentansprüche

1. Halbleitervorrichtung, die Folgendes umfasst:
einen Galliumnitrid-Kanalbereich, GaN-Kanalbereich, (206), der über einem Substrat angeordnet ist;
einen Gate-Stapel (222, 220), der auf dem GaN-Kanalbereich (206) angeordnet ist, wobei der Gate-Stapel (222, 220) eine zusammengesetzte dielektrische Gate-Schicht umfasst, die unmittelbar zwischen dem GaN-Kanalbereich (206) und einer Gate-Elektrode (224) angeordnet ist, wobei die zusammengesetzte dielektrische Gate-Schicht eine Schicht der Gruppe III-N mit hoher Bandlücke (222), wobei die Schicht der Gruppe III-N mit hoher Bandlücke (222) AlInN enthält, eine erste dielektrische High-K-Oxidschicht (220A) auf der Schicht der Gruppe III-N mit hoher Bandlücke (222), wobei die erste dielektrische High-K-Oxidschicht (220A) Aluminiumoxid, Al2O3, enthält, und eine zweite dielektrische High-K-Oxidschicht (220B) auf der ersten dielektrischen High-K-Oxidschicht (220A), wobei die zweite dielektrische High-K-Oxidschicht (220B) eine höhere dielektrische Konstante als die erste dielektrische High-K-Oxidschicht (220A) besitzt, umfasst; wobei die Gate-Elektrode auf der zweiten dielektrischen High-K-Oxidschicht angeordnet ist; und
Source-/Drain-Bereiche, die auf jeder Seite des GaN-Kanalbereichs (206) angeordnet sind.

2. Halbleitervorrichtung nach Anspruch 1, wobei die zweite dielektrische High-K-Oxidschicht (220B) Hafniumoxid, HfO₂, umfasst.

3. Halbleitervorrichtung nach einem der Ansprüche 1-2, wobei die zweite dielektrische High-K-Oxidschicht (220B) eine dielektrische Konstante besitzt, die größer als 15 ist, und die erste dielektrische High-K-Oxidschicht (220A) eine dielektrische Konstante besitzt, die kleiner als 15 ist.

4. Halbleitervorrichtung nach einem der Ansprüche 1-3, wobei die Halbleitervorrichtung eine N-Typ-Vorrichtung ist, die Gate-Elektrode (224) eine Mittelbandlückenmetall-Gate-Elektrode (224) ist und die Source- und Drain-Bereiche stark Si-dotierte GaN-Bereiche umfassen.

5. Halbleitervorrichtung nach einem der Ansprüche 1-4, wobei die Halbleitervorrichtung eine Verstärkungsbetriebsartvorrichtung ist.

6. Halbleitervorrichtung, die umfasst:
eine Heterostruktur, die über einem Substrat (302) angeordnet ist und einen dreidimensionalen Galliumnitrid-Körper, GaN-Körper, mit einem Oberflächen-GaN-Kanalbereich (206) umfasst;
einen Source- und einen Drain-Materialbereich (310), die über dem dreidimensionalen GaN-Körper angeordnet sind;
einen Graben, der in dem Source- und dem Drain-Materialbereich angeordnet ist und der einen Source-Bereich von einem Drain-Bereich trennt und zumindest einen Teil des Oberflächen-GaN-Kanalbereichs (206) freilegt; und
einen Gate-Stapel (222, 220), der in dem Graben und auf dem freigelegten Teil des Oberflächen-GaN-Kanalbereichs (206) angeordnet ist, wobei der Gate-Stapel (222, 220) eine zusammengesetzte dielektrische Gate-Schicht umfasst, die unmittelbar zwischen dem Oberflächen-GaN-Kanalbereich (206) und einer Gate-Elektrode (224) angeordnet ist, wobei die zusammengesetzte dielektrische Gate-Schicht eine Schicht der Gruppe III-N mit hoher Bandlücke (222), wobei die Schicht der Gruppe III-N mit hoher Bandlücke (222) AlInN enthält, eine erste dielektrische High-K-Oxidschicht (220A) auf der Schicht der Gruppe III-N mit hoher Bandlücke (222), wobei die erste dielektrische High-K-Oxidschicht (220A) Aluminiumoxid, Al₂O₃, enthält, und eine zweite dielektrische High-K-Oxidschicht (220B) auf der ersten dielektrischen High-K-Oxidschicht (220A), wobei die zweite dielektrische High-K-Oxidschicht (220B) eine höhere dielektrische Konstante als die erste dielektrische High-K-Oxidschicht (220A) besitzt, umfasst, wobei die Gate-Elektrode auf der zweiten dielektrischen High-K-Oxidschicht angeordnet ist.

7. Halbleitervorrichtung nach Anspruch 6, wobei die zweite dielektrische High-K-Oxidschicht (220B) Hafniumoxid, HfO₂, umfasst.

8. Halbleitervorrichtung nach einem der Ansprüche 6-7, wobei die zweite dielektrische High-K-Oxidschicht (220B) eine dielektrische Konstante besitzt, die größer als 15 ist, und die erste dielektrische High-K-Oxidschicht (220A) eine dielektrische Konstante besitzt, die kleiner als 15 ist.

9. Halbleitervorrichtung nach einem der Ansprüche 6-9, wobei die Halbleitervorrichtung eine N-Typ-Vorrichtung ist und die Gate-Elektrode (224) eine Mittelbandlückenmetall-Gate-Elektrode (224) ist.

10. Halbleitervorrichtung nach einem der Ansprüche 6-9, wobei die Halbleitervorrichtung eine Verstärkungsbetriebsartvorrichtung ist.

11. Halbleitervorrichtung nach einem der Ansprüche 6-10, wobei die Heterostruktur (304) ferner umfasst:
eine obere Barrierenschicht (326), die zwischen dem Source- und dem Drain-Materialbereich und dem dreidimensionalen GaN-Körper angeordnet ist, wobei der Graben auch in der oberen Barrierenschicht angeordnet ist; und
eine untere Barrierenschicht (328), die zwischen dem Substrat und dem dreidimensionalen GaN-Körper angeordnet ist, wobei der Graben auch teilweise in der unteren Barrierenschicht angeordnet ist, wobei sie den Oberflächen-GaN-Kanalbereich (206) vollständig freilegt und wobei der Gate-Stapel (222, 220) den Oberflächen-GaN-Kanalbereich (206) vollständig umgibt.

12. Verfahren zum Herstellen einer Halbleitervorrichtung, wobei das Verfahren umfasst:
Bilden eines Galliumnitrid-Kanalbereichs, GaN-Kanalbereichs, (206) über einem Substrat;
Bilden einer Schicht der Gruppe III-N mit hoher Bandlücke (222) auf dem GaN-Kanalbereich (308), wobei die Schicht der Gruppe III-N mit hoher Bandlücke (222) AlInN enthält;
Behandeln der Schicht der Gruppe III-N mit hoher Bandlücke (222) mit SF₆;
Bilden einer ersten dielektrischen High-K-Oxidschicht (220A) auf der Schicht der Gruppe III-N mit hoher Bandlücke (222), wobei die erste dielektrische High-K-Oxidschicht (220A) Aluminiumoxid, Al₂O₃, enthält;
Bilden einer zweiten dielektrischen High-K-Oxidschicht (220B) auf der ersten dielektrischen High-K-Oxidschicht (220A), wobei die zweite dielektrische High-K-Oxidschicht (220A) eine höhere dielektrische Konstante als die erste dielektrische High-K-Oxidschicht (220A) besitzt;
Bilden einer Gate-Elektrode (224) auf der zweiten dielektrischen High-K-Oxidschicht (220B); und
Bilden von Source-/Drain-Bereichen auf jeder Seite des GaN-Kanalbereichs (206).

13. Verfahren nach Anspruch 12, wobei das Bilden der Schicht der Gruppe III-N mit hoher Bandlücke (222) umfasst, die Schicht der Gruppe III-N mit hoher Bandlücke (222) zu einer erste Dicke zu bilden und anschließend die Schicht der Gruppe III-N mit hoher Bandlücke (222) zu einer zweiten kleineren Dicke zu ätzen.

## Revendications

1. Un dispositif semi-conducteur, comprenant :
une zone de canal (206) en nitrure de gallium, GaN, disposée au-dessus d'un substrat ;
un empilement de grilles (222, 220) disposé sur la zone de canal (206) en GaN, l'empilement de grilles (222, 220) comprenant une couche diélectrique de grille composite disposée directement entre la zone de canal (206) en GaN et une électrode de grille (224), la couche diélectrique de grille composite comprenant une couche à bande (222) interdite élevée du groupe III-N, la couche (222) à bande interdite élevée du groupe III-N comprenant du AlInN, une première couche (220A) d'oxyde diélectrique à K élevé sur la couche (222) à bande interdite élevée du groupe III-N, la première couche (220A) d'oxyde diélectrique à K élevé comprenant de l'oxyde d'aluminium, Al₂O₃, et une deuxième couche (220B) d'oxyde diélectrique à K élevé sur la première couche (220A) d'oxyde diélectrique à K élevé, la deuxième couche (220B) d'oxyde diélectrique à K élevé ayant une constante diélectrique plus élevée que la première couche (220A) d'oxyde diélectrique à K élevé ; l'électrode de grille étant disposée sur la deuxième couche d'oxyde diélectrique à K élevé ; et
des zones source/drain étant disposées de part et d'autre de la zone de canal (206) en GaN.

2. Le dispositif semi-conducteur selon la revendication 1, dans lequel la deuxième couche (220B) d'oxyde diélectrique à K élevé comprend de l'oxyde d'hafnium, HfO₂.

3. Le dispositif semi-conducteur selon l'une des revendications 1 à 2, dans lequel la deuxième couche (220B) d'oxyde diélectrique à K élevé a une constante diélectrique supérieure à 15, et la première couche (220A) d'oxyde diélectrique à K élevé a une constante diélectrique inférieure à 15.

4. Le dispositif semi-conducteur selon l'une des revendications 1 à 3, dans lequel le dispositif semi-conducteur est un dispositif de type N, l'électrode de grille (224) est une électrode de grille métallique (224) à mi-intervalle, et les zones de source et de drain comprennent des zones en GaN fortement dopées au Si.

5. Le dispositif semi-conducteur selon l'une des revendications 1 à 4, dans lequel le dispositif semi-conducteur est un dispositif à mode d'enrichissement.

6. Un dispositif semi-conducteur, comprenant :
une hétérostructure disposée au-dessus d'un substrat (302) et comprenant un corps tridimensionnel en nitrure de gallium, GaN, avec une zone de canal de surface (206) en GaN ;
une zone de matériau de source et de drain (310) disposée au-dessus du corps en GaN tridimensionnel ;
une tranchée disposée dans la zone de matériau de source et de drain séparant une zone de source d'une zone de drain, et exposant au moins une partie de la zone de canal de surface (206) en GaN ; et
un empilement de grilles (222, 220) disposé dans la tranchée et sur la partie exposée de la zone de canal de surface (206) en GaN, l'empilement de grilles (222, 220) comprenant une couche diélectrique de grille composite disposée directement entre la zone de canal de surface (206) en GaN et une électrode de grille (224), la couche diélectrique de grille composite comprenant une couche (222) à bande interdite élevée du groupe III-N, la couche (222) à bande interdite élevée du groupe III-N comprenant du AlInN, une première couche (220A) d'oxyde diélectrique à K élevé sur la couche (222) à bande interdite élevée du groupe III-N, la première couche (220A) d'oxyde diélectrique à K élevé comprenant de l'oxyde d'aluminium, Al₂O₃, et une deuxième couche (220B) d'oxyde diélectrique à K élevé sur la première couche (220A) d'oxyde diélectrique à K élevé, la deuxième couche (220B) d'oxyde diélectrique à K élevé ayant une constante diélectrique plus élevée que la première couche (220A) d'oxyde diélectrique à K élevé, et l'électrode de grille est disposée sur la deuxième couche d'oxyde diélectrique à K élevé.

7. Le dispositif semi-conducteur selon la revendication 6, dans lequel la deuxième couche (220B) d'oxyde diélectrique à K élevé comprend de l'oxyde d'hafnium, HfO₂.

8. Le dispositif semi-conducteur selon l'une des revendications 6 à 7, dans lequel la deuxième couche (220B) d'oxyde diélectrique à K élevé a une constante diélectrique supérieure à 15, et la première couche (220A) d'oxyde diélectrique à K élevé a une constante diélectrique inférieure à 15.

9. Le dispositif semi-conducteur selon l'une des revendications 6 à 9, dans lequel le dispositif semi-conducteur est un dispositif de type N, et l'électrode de grille (224) est une électrode de grille métallique (224) à mi-intervalle.

10. Le dispositif semi-conducteur selon l'une des revendications 6 à 9, dans lequel le dispositif semi-conducteur est un dispositif à mode d'enrichissement.

11. Le dispositif semi-conducteur selon l'une des revendications 6 à 10, l'hétérostructure (304) comprenant en outre :
une couche barrière supérieure (326) disposée entre la zone de matériau de source et de drain et le corps en GaN tridimensionnel, la tranchée étant également disposée dans la couche barrière supérieure ; et
une couche barrière inférieure (328) disposée entre le substrat et le corps en GaN tridimensionnel, la tranchée étant également disposée dans la couche barrière inférieure, exposant complètement la zone de canal de surface (206) en GaN, et l'empilement de grilles (222, 220) entourant complètement la zone de canal de surface (206) en GaN.

12. Un procédé de fabrication d'un dispositif semi-conducteur, le procédé comprenant :
le fait de former une zone de canal (206) en nitrure de gallium, GaN, au-dessus d'un substrat ;
le fait de former une couche (222) à bande interdite élevée du groupe 111-N sur la zone de canal (308) en GaN, la couche (222) à bande interdite élevée du groupe 111-N comprenant du AlInN ;
le fait de traiter la couche (222) à bande interdite élevée du groupe 111-N avec du SF₆ ;
le fait de former une première couche (220A) d'oxyde diélectrique à K élevé sur la couche (222) à bande interdite élevée du groupe III-N, la première couche (220A) d'oxyde diélectrique à K élevé comprenant de l'oxyde d'aluminium, Al₂O₃ ;
le fait de former une deuxième couche (220B) d'oxyde diélectrique à K élevé sur la première couche (220A) d'oxyde diélectrique à K élevé, la deuxième couche (220B) d'oxyde diélectrique à K élevé ayant une constante diélectrique plus élevée que la première couche (220A) d'oxyde diélectrique à K élevé ;
le fait de former une électrode de grille (224) sur la deuxième couche (220B) d'oxyde diélectrique à K élevé ; et
le fait de former des zones source/drain de chaque côté de la zone de canal (206) en GaN.

13. Le procédé selon la revendication 12, dans lequel la formation de la couche (222) à bande interdite élevée du groupe 111-N comprend le fait de former la couche (222) à bande interdite élevée du groupe 111-N selon une première épaisseur et, par la suite, le fait de graver la couche (222) à bande interdite élevée du groupe III-N à une deuxième épaisseur moindre.
